# EUROPÄISCHE PATENTSCHRIFT

(11) **EP 2 508 934 B1**
(45) Veröffentlichungstag und Bekanntmachung des Hinweises auf die Patenterteilung: **11.05.2016**
(21) Anmeldenummer: 12162400.1
(22) Anmeldetag: 30.03.2012
(51) Int. Cl.: G02B 27/09, H01S 5/40

(54) **Diodenlaser**
Diode Laser
Laser à diodes

(30) Priorität: 06.04.2011 DE 102011016253
(43) Veröffentlichungstag der Anmeldung: 10.10.2012
(73) Patentinhaber: Laserline Gesellschaft für Entwicklung und Vertrieb von Diodenlasern mbH, 56218 Mülheim-Kärlich (DE)
(72) Erfinder: Krause, Volker, 56295 Lonnig (DE); Kösters, Arnd, 55425 Waldalgesheim (DE); Rehmann, Georg, 56070 Koblenz (DE); Dünnwald, Daniel, 56170 Bendorf (DE); Malchus, Jörg, 56727 Sankt Johann (DE); Baumann, Markus, 56218 Mülheim-Kärlich (DE)
(74) Vertreter: Glück Kritzenberger Patentanwälte PartGmbB

(56) Entgegenhaltungen:
- DE-A1- 10 012 480
- DE-A1- 19 743 322
- DE-A1- 19 918 444

## Beschreibung

Die Erfindung bezieht sich auf einen Diodenlaser entsprechend Oberbegriff Patentanspruch 1.

Im Gegensatz zu konventionellen Laserstrahlquellen, die einen Strahldurchmesser von einigen mm bei einer geringen Strahldivergenz im Bereich von wenigen mrad aufweisen, zeichnet sich die Strahlung eines Halbleiter- oder Diodenlasers (nachstehend "Diodenlaser") durch einen in der Fast-Axis stark divergenten Strahl mit einer Divergenz > 1000 mrad aus. Hervorgerufen wird dies von der auf < 1 µm Höhe begrenzten Austrittsschicht, an der ähnlich der Beugung an einer spaltförmigen Öffnung, ein großer Divergenzwinkel erzeugt wird. Da die Ausdehnung der Austrittsöffnung in der Ebene senkrecht und parallel zur aktiven Halbleiterschicht unterschiedlich ist, kommen verschiedene Strahldivergenzen in der Ebene senkrecht und parallel zur aktiven Schicht zustande.

Um eine Leistung von 20 - 40 W für einen Diodenlaser zu erreichen, werden zahlreiche Laser-Emitter auf einem sog. Laserbarren zu einem Laserbauelement zusammengefasst. Üblicherweise werden hierbei 10 - 50 einzelne Emittergruppen in einer Reihe in der Ebene parallel zur aktiven Schicht angeordnet. Der resultierende Strahl eines solchen Barrens hat in der Ebene parallel zur aktiven Schicht einen Öffnungswinkel von ca. 10° und einen Strahldurchmesser von ca. 10 mm. Die resultierende Strahlqualität in dieser Ebene ist um ein Vielfaches geringer als die sich ergebende Strahlqualität in der zuvor beschriebenen Ebene senkrecht zur aktiven Schicht. Auch bei einer möglichen zukünftigen Verringerung der Divergenzwinkel von Laser-Chips bleibt das stark unterschiedliche Verhältnis der Strahlqualität senkrecht und parallel zur aktiven Schicht bestehen.

Der Strahl verfügt aufgrund der zuvor beschriebenen Strahlcharakteristik über einen großen Unterschied der Strahlqualität in beiden Richtungen senkrecht und parallel zur aktiven Schicht. Der Begriff der Strahlqualität wird dabei beschrieben durch den M² Parameter. M² ist definiert durch den Faktor, mit dem die Strahldivergenz des Diodenlaserstrahles über der Strahldivergenz eines beugungsbegrenzten Strahles gleichen Durchmessers liegt. In dem oben gezeigten Fall verfügt man in der Ebene parallel zur aktiven Schicht über einen Strahldurchmesser, der um den Faktor 10.000 über dem Strahldurchmesser in der senkrechten Ebene liegt. Bei der Strahldivergenz verhält es sich anders, d.h. in der Ebene parallel zur aktiven Schicht bzw. in der Slow-Axis wird eine fast 10-fach kleinere Strahldivergenz erreicht. Der M² Parameter in der Ebene parallel zur aktiven Schicht liegt also um mehrere Größenordnungen über dem M² Wert in der Ebene senkrecht zur aktiven Schicht.

Ein mögliches Ziel einer Strahlformung ist es, einen Strahl mit nahezu gleichen M² Werten in beiden Ebenen, d.h. senkrecht und parallel zur aktiven Schicht zu erreichen. Bekannt sind derzeit folgende Verfahren zur Umformung der Strahlgeometrie durch die eine Annäherung der Strahlqualitäten in den beiden Hauptebenen des Strahles erreicht wird.

Mittels eines Faserbündels lassen sich linienförmige Strahlquerschnitte durch Umordnen der Fasern zu einem kreisrunden Bündel zusammenfassen. Solche Verfahren sind z.B. in den US-Patentschriften 5 127 068, 4 763 975, 4 818 062, 5 268 978 sowie 5 258 989 beschrieben.

Daneben besteht die Technik des Strahldrehens, bei dem die Strahlung einzelner Emitter um 90° gedreht wird, um so eine Umordnung vorzunehmen bei der eine Anordnung der Strahlen in Richtung der Achse der besseren Strahlqualität erfolgt. Zu diesem Verfahren sind folgende Anordnungen bekannt: US 5 168 401, EP 0 484 276, DE 4 438 368. Allen Verfahren ist gemein, dass die Strahlung eines Diodenlasers nach dessen Kollimation in der Fast-Axis-Richtung, um 90° gedreht wird um eine Slow-Axis-Kollimation mit einer gemeinsamen Zylinderoptik vorzunehmen. In Abwandlung der genannten Verfahren ist auch eine durchgehende Linienquelle denkbar (z.B. die eines in Fast-Axis-Richtung kollimierten Diodenlasers hoher Belegungsdichte), deren Strahlprofil (Linie) aufgeteilt wird und in umgeordneter Form hinter dem optischen Element vorliegt.

Daneben besteht die Möglichkeit, ohne eine Drehung des Strahles eine Umordnung der Strahlung einzelner Emitter vorzunehmen, wobei durch z.B. durch den parallelen Versatz (Verschieben) mittels paralleler Spiegel eine Umordnung der Strahlung erreicht wird (WO 95/15510). Eine Anordnung, die sich ebenfalls der Technik des Umordnens bedient, ist in DE 19 5 44 488 beschrieben. Hierbei wird die Strahlung eines Diodenlaserbarrens in verschiedene Ebenen abgelenkt und dort einzeln kollimiert.

Die Nachteile des Standes der Technik lassen sich u.a. dahingehend zusammenfassen, dass bei fasergekoppelten Diodenlasern meist ein Strahl mit sehr unterschiedlichen Strahlqualitäten in beiden Achsrichtungen in die Faser eingekoppelt wird. Bei einer kreisrunden Faser bedeutet dies, dass in einer Achsrichtung die mögliche numerische Apertur oder der Faserdurchmesser nicht genutzt wird. Dies führt zu erheblichen Verlusten bei der Leistungsdichte, sodass in der Praxis eine Beschränkung auf ca. 10⁴ W/cm² erfolgt.

Bei den genannten bekannten Verfahren müssen weiterhin teilweise erhebliche Weglängenunterschiede kompensiert werden. Dies geschieht meist durch Korrekturprismen, die Fehler nur begrenzt ausgleichen können. Vielfachreflexionen stellen weiterhin erhöhte Anforderungen an Justagegenauigkeit, Fertigungstoleranzen sowie Bauteilstabifität (WO 95/15510). Reflektierende Optiken (z.B. aus Kupfer) verfügen über hohe Absorptionswerte.

Bekannt ist weiterhin eine Laseroptik der gattungsbildenden Art zum Umformen wenigstens eines Laserstrahlenbündels, unter Verwendung von wenigstens zwei im Strahlengang aufeinander folgend angeordneten optischen Umformelementen, die als sogenannter Plattenfächer ausgebildet sind (DE 10012480 A1).

Bei bisher bekannten Diodenlasern ist die Strahlungsleistung der Diodenlaseranordnung begrenzt, und zwar insbesondere dadurch, dass die zur Verfügung stehenden Laserbarren in ihrer Slow-Axis (ebene der Emitterschichten) eine begrenzte Länge, beispielsweise eine Länge von etwa 10 mm aufweisen und die typische optische Ausgangsleistung eine Laserbarrens beispielsweise im Bereich von maximal 250 Watt liegt. Wegen der Abmessungen, die insbesondere auch die als Träger für die Laserbarren dienenden Wärmesenken in Richtung der Fast-Axis aufweisen, in der die Laserbarren stapelartig gegeneinander versetzt in der Laserdiodenanordnung vorgesehen sind, sowie auch wegen der Notwendigkeit von optischen Elementen, die für die Fast-Axis-Kollimation an den einzelnen Laserbarren vorgesehen werden müssen, ist die Stapeldichte der Laserbarren innerhalb des diese Laserbarren und die zugehörigen Träger bzw. Wärmetauscher aufweisenden Stapels begrenzt.

Aufgabe der Erfindung ist es, einen Diodenlaser aufzuzeigen, der eine verbesserte optische Leistung ohne Einbußen der Strahlqualität ermöglicht. Zur Lösung dieser Aufgabe ist ein Diodenlaser entsprechend dem Patentanspruch 1 ausgebildet.

Durch die wenigstens zwei Stapel der Laserdiodenanordnung ist praktisch die doppelte optische Leistung bei gleicher Größe und Stapeldichte der Laserbarren erreichbar, und zwar ohne Einbuße der Strahlenqualität der Laserstrahlung nach dem Umformen.

Bei der Erfindung weist die die Laserstrahlung erzeugende Laserdiodenanordnung wenigstens zwei parallele und in Richtung der Slow-Axis gegeneinander versetzte Stapel jeweils bestehend aus einer Vielzahl von Laserbarren und zugehörigen Trägern bzw. Wärmesenken auf. Sämtliche Laserbarren sind dabei mit ihrer Längserstreckung bzw. Slow-Axis parallel zueinander angeordnet. Die im Strahlengang auf die Laserdiodenanordnung und/oder auf dortige Fast-Axis-Kollimatoren folgende und zur Strahlformung dienende erste Plattenfächeranordnung ist als Fast-Axis-Plattenfächeranordnung ausgeführt, und zwar für eine Auffächerung der von den Laserbarren erzeugten Strahlenbündel in jeweils mehrere in Richtung der Fast-Axis der Laserstrahlung gegen einander versetzte Einzel-Strahlenbündel, die dann in einer im Strahlengang folgenden Slow-Axis-Plattenfächeranordnung in Richtung der Slow-Axis zusammen geschoben bzw. übereinander geschoben werden. Die Fast-Axis-Plattenfächeranordnung weist hierfür wenigstens zwei parallele und in Richtung der Slow-Axis der Laserstrahlung voneinander beabstandete Fast-Axis-Plattenfächer auf, die jeweils aus wenigstens zwei Platten bestehen. Bei einer Ausführungsform der Erfindung sind diese Fast-Axis-Plattenfächer relativ zueinander um eine Achse parallel zur Slow-Axis der Laserstrahlung verschwenkt, sodass die Auffächerung der von den Laserbarren jedes Stapels erzeugten Strahlenbündel eine Anordnung von gegen einander versetzten aufgefächerten Einzel-Strahlenbündel, die (Anordnung) von der entsprechenden Anordnung der aufgefächerten Einzel-Strahlenbündel eines anderen Stapels einer Achsrichtung senkrecht zum Strahlengang der Laserstrahlung versetzt ist, vorzugsweise in der Fast-Axis.

Durch entsprechende Anordnung und/oder Ausbildung der Fast-Axis-und Slow-Axis-Piattenfächeranordnungen die Auffächerung Strahlenbündel so auszubilden, dass die aufgefächerten Einzel-Strahlenbündel sämtlicher Stapel in einer gemeinsamen Ebene vermischt und/oder sich überdeckend oder überlappend vorgesehen sind.

Bevorzugt ist der Strahlengang nach der Slow-Axis-Plattenfächeranordnung eine Slow-Axis-Kollimations-Optik vorgesehen, sodass dann eine parallele oder im Wesentlichen parallele Laserstrahlung erhalten ist.

Unter "Ptattenfächer" ist im Sinne der Erfindung ein vom Laserlicht durchstrahltes optisches Element zu verstehen, welches sich aus wenigstens zwei Platten oder plattenförmigen Elementen aus einem Licht leitenden Material, vorzugsweise aus optischen Glas, zusammensetzt, die stapelartig aneinander anschließen und fächerartig gegen einander verdreht sind. Jede Platte oder jedes plattenförmige Element bildet an einander gegenüberliegenden Seiten eine Plattenschmalseite oder einen Plattenrandbereich für den Lichteintritt oder -austritt. Unter "Oberflächenseiten der Platten" sind im Sinne der Erfindung jeweils die großen Plattenseiten zu verstehen.

Die Platten sind beispielsweise unter Berücksichtigung der Anordnung der Emitter und der Divergenz, die die Laserstrahlen in der Slow-Axis aufweisen, so positioniert und ausgebildet, dass an den Oberflächenseiten innerhalb der Platte eine Reflexion des jeweiligen Laserstrahl nicht erfolgt.

Unter "Plattendicke" ist im Sinne der Erfindung der Abstand zu verstehen, den die beiden Oberflächenseiten der jeweiligen Platte von einander aufweisen.

Der jeweilige Plattenfächer kann durch Zusammensetzen aus einzelnen Platten oder plattenförmigen Elementen oder aber auch einstückig, beispielsweise als Formteil mit entsprechenden optischen Trenn- oder Zwischenschichten hergestellt sein.

Eine "Fast-Axis-Plattenfächeranordnung" oder ein "Fast-Axis-Plattenfächer" ist im Sinne der Erfindung eine Plattenfächeranordnung oder ein Plattenfächer, mit der bzw. mit dem eine Auffächerung der Strahlenbündel in der Fast-Axis erfolgt.

Eine "Slow-Axis-Plattenfächeranordnung" oder ein "Slow-Axis-Plattenfächer" ist im Sinne der Erfindung eine Plattenfächeranordnung oder ein Plattenfächer, mit der bzw. mit dem ein Zusammenführen der aufgefächerten Strahlenbündel in der Slow-Axis erfolgt.

Der Ausdruck "im Wesentlichen" bzw. "etwa" bedeutet im Sinne der Erfindung Abweichungen von jeweils exakten Werten um +/-10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an einem Ausführungsbeispiel näher erläutert. Es zeigen:
- Fig. 1: in vereinfachter Darstellung einen Diodenlaser mit einer eine Vielzahl von Laserelementen oder Laserchips (Laserbarren) aufweisenden Laserdiodenanordnung und einer im Strahlengang dieser Laserdiodenanordnung angeordneten optischen Anordndung zur Formung und Fokussierung des Laserstrahls, wobei die Zeichenebene der Figur 1 senkrecht zur aktiven Schicht der Laserdiodenelemente orientiert ist;
- Fig. 2: den Diodenlaser der Figur 1 in Draufsicht, wobei die Zeichenebene der Figur 2 parallel zur aktiven Schicht der Laserdiodenelemente orientiert ist;
- Fig. 3: in Einzeldarstellung einen der Fast-Axis-Plattenfächer der Fast-Axis-Plattenfächeranordnung;
- Fig. 4: zwei parallele sowie voneinander beabstandete Fast-Axis-Plattenfächer der Fast-Axis-Plattenfächeranordnung in Draufsicht;
- Fig. 5: in den Positionen a - c in vereinfachter Darstellung das Auffächern der Strahlenbündel eines Stapels der Laserdiodenanordnung in die Einzel-Strahlenbündel und das anschließende Zusammenführen der Einzel-Strahlenbündel zu dem umgeformten Strahlenbündel.

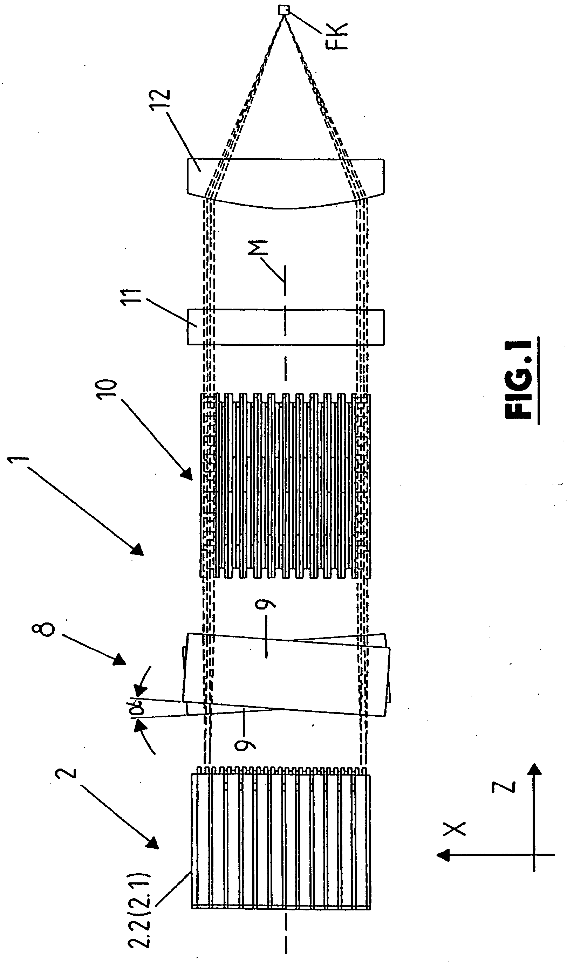

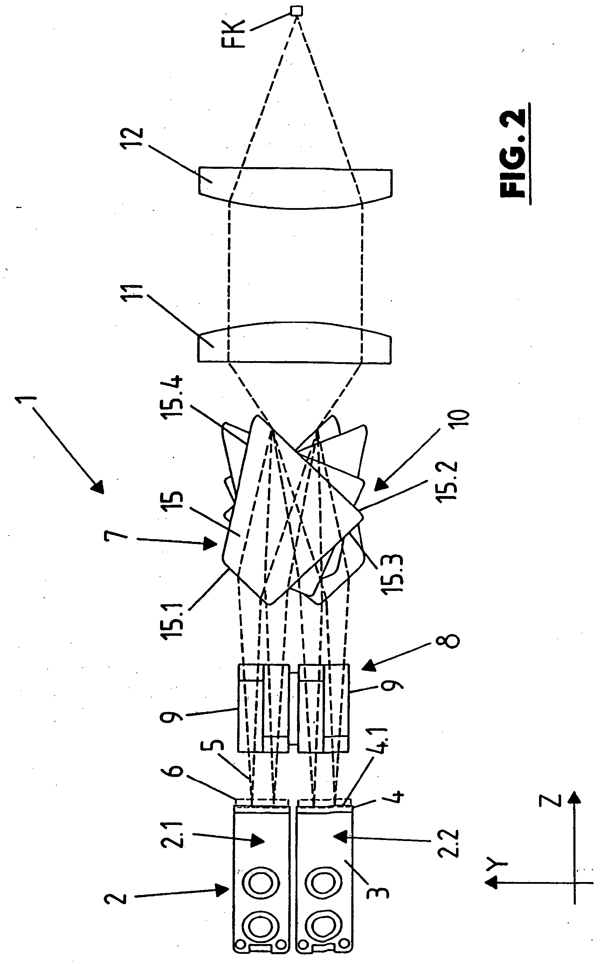

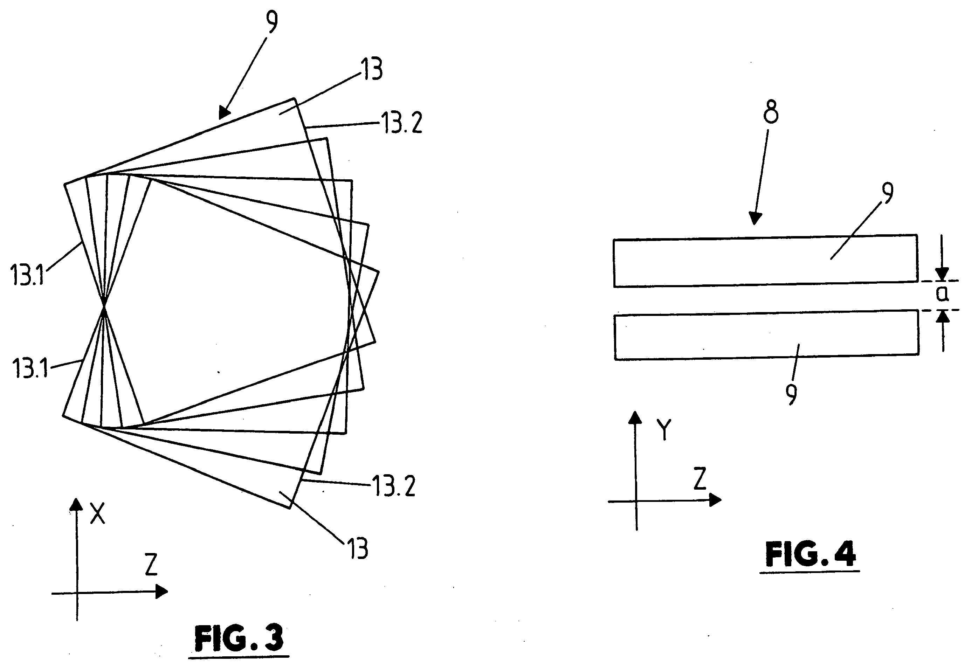

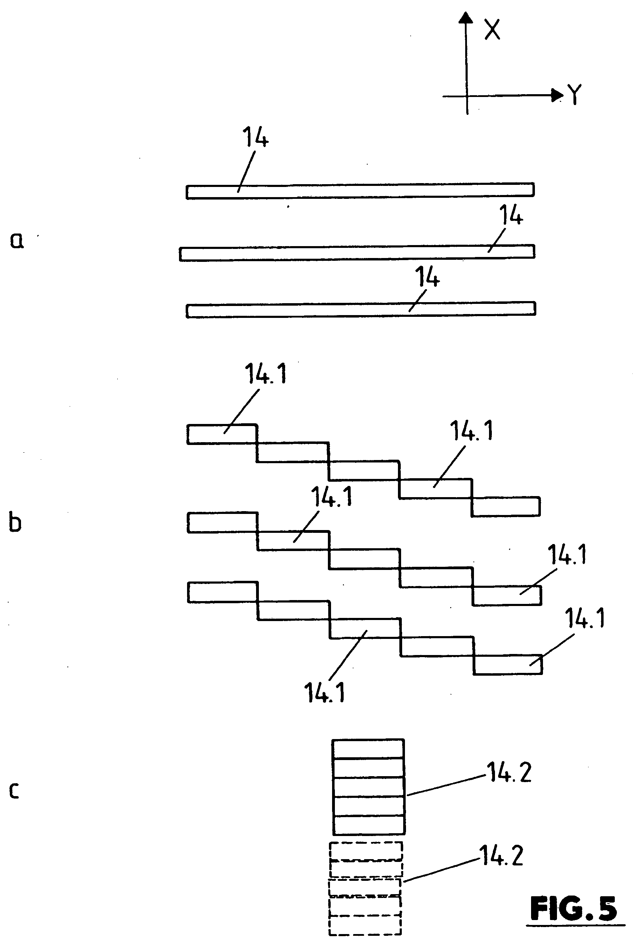

In den Figuren sind der besseren Übersichtlichkeit wegen sowie zum besseren Verständnis jeweils mit X, Y und Z die senkrecht zueinander orientierten Raumachsen bezeichnet, nämlich X-Achse, Y-Achse und Z-Achse. Die Zeichenebene der Figur 1 und 3 ist dementsprechend die von der X-Achse und der Z-Achse definierten XZ-Ebene, die Zeichenebene der Figuren 2 und 4 die von der Y-Achse und der Z-Achse definierte YZ-Ebene und die Zeichenebene der Figur 5 die von der X-Achse und der Y-Achse definierte XY-Ebene.

Der in den Figuren dargestellte Diodenlaser 1 besteht im Wesentlichen aus einer Laserdiodenanordnung 2, die bei der dargestellten Ausführungsform aus zwei parallelen Stapeln 2.1 und 2.2 jeweils aus einer Vielzahl von Wärmesenken 3 und an diesen vorgesehenen Laserbarren 4 besteht. Die Wärmesenken 3 und die Laserbarren 4 sind bei der dargestellten Ausführungsform in jedem Stapel 2.1 und 2.2 identisch ausgebildet. Weiterhin sind die Wärmesenken 3 und die Laserbarren 4 des Stapels 2.1 identisch mit den Wärmesenken 3 und Laserbarren 4 des Stapels 2.2. Die Wärmesenken 3 sind bei der dargestellten Ausführungsform weiterhin jeweils quaderförmig und als aktive Wärmesenken ausgebildet, d.h. als Wärmesenken, die von einem vorzugsweise flüssigen Wärme transportierenden Medium oder Kühlmedium durchströmt werden.

Die Wärmesenken 3, die in jedem Stapel 2.1 und 2.2 so aneinander anschließen, dass sie mit in der YZ-Ebene angeordneten Ober- und Unterseiten vorzugsweise über eine isolierende Zwischenschicht (z.B. Keramikschicht) gegeneinander anliegen, sind mit ihren Längsseiten jeweils in der Z-Achse orientiert und an einer sich in Richtung der Y-Achse erstreckenden Schmalseite jeweils mit dem Laserbarren 4 versehen. Weiterhin sind die Stapel 2.1 und 2.2 in der Y-Achse gegeneinander versetzt parallel zueinander so angeordnet, dass die Laserbarren 4 beider Stapel 2.1 und 2.2 mit ihren Laser-Licht aussendenden Emittern 4.1 oder dem Laser-Licht-Austritt in einer gemeinsamen XY-Ebene oder im Wesentlichen in einer gemeinsamen XY-Ebene angeordnet sind und beispielsweise jeweils ein Laserbarren 4 eines Stapels in der Y-Achse achsgleich mit einem Laserbarren 4 des anderen Stapels angeordnet ist.

Jeder Laserbarren 4, der in Richtung der Y-Achse bei einer Resonatorlänge von etwa 2 bis 4 mm eine Breite von beispielsweise etwa 10 mm besitzt, weist Vielzahl von Laser-Licht aussendenden Emittern 4.1, die in Richtung der Y-Achse aufeinander folgend und gegeneinander versetzt an dem Chip oder Laserbarren 4 gebildet sind. Die typische optische Ausgangsleistung eines Laserbarrens 4 liegt beispielsweise bei maximal 250 Watt. In der Slow-Axis, die der Y-Achse entspricht, liegt der Abstrahlwinkel bzw. die Laser-Strahl-Divergenz der Einzel-Laserstrahlen 5 im Bereich zwischen 5° und 10°. In der Fast-Axis, die der X-Achse entspricht, liegt der Abstrahlwinkel bzw. die Laser-Strahl-Divergenz der Einzel-Laserstrahlen 5 im Bereich zwischen etwa 25°und 50°. Zur Kollimation der Laser-Strahlen 5 in der Fast-Axis, d.h. in der X-Achse sind die Laserbarren 4 jeweils mit einem Fast-Axis-Kollimator 6 versehen, der beispielsweise aus einem durchgehenden, für jeden Laserbarren 4 vorgesehenen und als Fast-Axis wirkenden optischen Element (z.B. Zylinderlinse) oder aber aus einzelnen als Fast Axis-Kollimator wirkenden optischen Elementen besteht, von denen jedes einer Gruppe von Emittern 4.1 zugeordnet ist. Typischerweise besteht jeder Fast-Axis-Kollimator 6 aus zwei Elementen oder Linsen mit jeweils einer Brennweite beispielsweise im Bereich zwischen 0,3 und 1,0 mm, wobei durch individuelle Einstellung dieser Linsen auch ein sogenannter Smile-Effekt kompensiert werden kann, der aus dem insbesondere thermischen Verbiegen des betreffenden Laserbarrens 4 während des Betriebes des Diodenlasers 1 gegenüber der YZ-Ebene resultiert.

Zum Formen und insbesondere auch zur Fokussierung der von der Laserdiodenanordnung 2 gelieferten Laserstrahlung umfasst der Diodenlaser 1 eine in den Figuren allgemein mit 7 bezeichnete optische Anordnung (Laseroptik), die bei der dargestellten Ausführungsform aus einer Fast-Axis-Plattenfächeranordnung 8 mit zwei parallelen Fast-Axis-Plattenfächern 9, aus einem Slow-Axis-Plattenfächer 10, aus einem als Slow-Axis-Kollimator wirkenden optischen Element 11 (z.B. in Form einer Zylinderlinse) sowie aus einer zur Fokussierung der Laserstrahlung in den Fokus FK geeigneten Fokussieroptik 12, beispielsweise in Form wenigstens einer Fokussier-Linse besteht. Im Detail sind die vorgenannten Elemente der optischen Anordnung 7 im Strahlengang der Laser-Strahlung der Laserdiodenanordnung 2 bzw. in der Z-Achse derart angeordnet, dass die Fast-Axis-Plattenfächeranordnung 8 bzw. deren Fast-Axis-Plattenfächer 9 unmittelbar auf die Diodenanordnung 2 bzw. auf die dortigen Fast-Axis-Kollimatoren 6 folgen, der Slow-Axis-Plattenfächer 10 auf die Fast-Axis-Plattenfächeranordnung 8, das optische Element 11 auf den Slow-Axis-Plattenfächer 10 und Fokussieroptik 12 auf das optische Element11 folgen.

Fast-Axis-Die Plattenfächer 9 bestehen jeweils aus mehreren Platten 13 aus einem Licht leitenden Material, beispielsweise aus einem optischen Glas. Die Platten 13 sind in jedem Fast-Axis-Plattenfächer 9 identisch ausgeführt. Weiterhin sind bei der dargestellten Ausführungsform die Platten 13 des einen Fast-Axis-Plattenfächers 9 auch identisch mit den Platten 13 des anderen Fast-Axis-Plattenfächers 9 der Plattenfächeranordnung 8.

Jeder Fast-Axis-Plattenfächer 9 weist bei der dargestellten Ausführungsform fünf Platten 13 auf, wobei die Anzahl der Platten 13 auch anders gewählt sein kann. Beispielsweise können die Fast-Axis-Plattenfächer 9 auch nur jeweils zwei Platten 13 aufweisen.

Die Platten 13 sind mit ihren Plattenebenen in der XZ-Ebene angeordnet und liegen mit ihren Plattenebenen dicht gegeneinander an. Weiterhin erstrecken sich die Platten 13 und damit auch die Fast-Axis-Plattenfächer 9 in der X-Achse zumindest über die gesamte Höhe, die die Laserdiodenanordnung bzw. die beiden Stapel 2.1 und 2.2 in dieser Achse aufweisen. Jede Platte 13 bildet zwei parallele, in Richtung der Z-Achse gegeneinander versetzte Schmalseiten oder Plattenrandbereiche 13.1 und 13.2, von denen die der Laserdiodenanordnung 2 zugewandte Schmalseite 13.1 die Eintrittsseite und die der Laserdiodenanordnung 2 abgewandte Schmalseite 13.2 die Austrittsseite für die Laserstrahlung bildet. Die Platten 13, die bei der dargestellten Ausführungsform rechteckförmig ausgeführt sind und bei denen die jeweils senkrecht zu den Oberflächenseiten der jeweiligen Platte 13 orientierten planen Plattenrandbereiche 13.1 und 13.2 die Längsseiten der Platten 13 bilden, sind um eine in Richtung der Y-Achse orientierte Mittelachse fächerartig gegeneinander verschwenkt, sodass jeder Plattenrandbereich 13.1 bzw. 13.2 einer Platte 13 gegenüber dem entsprechenden Plattenrandbereich 13.1 bzw. 13.2 der benachbarten Platte 13 einen Winkelversatz deutlich kleiner als 90° aufweist.

Die Dicke der Platten 13 ist bevorzugt so gewählt, däss sie zumindest gleich, vorzugsweise aber größer ist als die Divergenz, die die Strahlenbündel aus den der Einzellaserstrahlen 5 aufweisen, die jeweilige Platte 13 durchstrahlen, sodass innerhalb der Platten 13 keine Totalreflektion im Bereich der Oberflächenseiten der Platten 13 erfolgt.

Wie insbesondere die Figur 2 zeigt, ist jedem Stapel 2.1 und 2.2 ein Fast-Axis-Plattenfächer 9 der Fast-Axis-Plattenfächeranordnung 8 zugeordnet. Die Breite, die jeder Plattenfächer 9 in Richtung der Y-Achse aufweist, ist dabei gleich der Breite oder der effektiven Breite, die die Laserbarren 4 in dem betreffenden Stapel 2.1 bzw. 2.2 ebenfalls in der Y-Achse besitzen. Unter effektiver Breite ist dabei der Abstand zwischen den beiden äußeren Emittern 4.1 des betreffenden Laserbarrens 4 zu verstehen.

Da es aufgrund der Ausbildung der Laserbarren 4 und auch aus konstruktiven Gründen nicht möglich ist, die Stapel 2.1 und 2.2 bzw. deren Laserbarren 4 derart anzuordnen, dass in jeder YZ-Ebene die Emitter 4.1 eines Laserbarrens 4 des Stapels 2.1 an die Emitter 4.1 des entsprechenden Laserbarrens 4 des Stapels 2.2 übergangslos und unter Beibehaltung desjenigen Rasterabstandes anzuschließen, den die Emitter innerhalb der Laserbarren 4 in Richtung der Y-Achse aufweisen, vielmehr ein gegenüber dem Rasterabstand vergrößerter Versatz in Richtung der Y-Achse zwischen einem Laserbarren 4 des Stapels 2.1 und einem Laserbarren 4 des Stapels 2.2 in der selben YZ-Ebene unvermeidbar ist, beispielsweise ein Versatz in der Größenordnung von etwa 6mm, sind auch die beiden parallelen und identisch ausgebildeten Fast-Axis-Plattenfächer 9 der Fast-Axis-Plattenfächeranordnung 8 diesem Versatz entsprechend in der Y-Achse versetzt bzw. mit dem Abstand a angeordnet.

Wie die Figur 1 zeigt, sind die identischen Fast-Axis-Plattenfächer 9 auch um die in Richtung der Y-Achse orientierte Plattenfächerachse relativ zueinander um einen spitzen Winkel α verdreht, und zwar bei der dargestellten Ausführungsform derart, dass jede Plattenfächer 9 jeweils um den selben Winkel aber entgegen gesetzt gegenüber der YZ-Ebene geneigt sind.

Zur Erläuterung der Wirkweise der Plattenfächer 9 wird auf die Positionen 4a und 4b der Figur 5 verwiesen. In der Position 4a ist sehr schematisch die von den Laserbarren 4 eines Stapels 2.1 oder 2.2 abgegebene Laserstrahlung als balkenförmiges Strahlenbündel 14 wiedergegeben, und zwar der einfacheren Darstellung wegen lediglich für drei in unterschiedlichen YZ-Ebenen angeordnete Laserbarren 4. Bei Annahme von fünf Platten 13 des Fast-Axis-Plattenfächer 9 erfolgt mit diesem Plattenfächer eine Auffächerung jedes Strahlenbündels 14 in fünf Einzel-Strahlenbündel 14.1, die dann treppenartig in der X-Achse gegeneinander versetzt sind (Position b). Mit Hilfe des Slow-Axis-Plattenfächers 10 werden die Einzel-Strahlenbündel 14.1 dann in Richtung der Slow-Axis bzw. der Y-Achse derart übereinander geschoben, sodass sich das in der Position c dargestellte umgeformte Strahlenbündel 14.2 ergibt. In gleicher Weise erfolgt auch das Umformen der von den Laserbarren 4 des Stapels 2.2 ausgehenden Strahlenbündel 14 in das Strahlenbündel 14.2, das dann das Strahlenbündel 14.2 des Stapels 2.1 überlappt oder parallel zu dem Strahlenbündel 14.2 des Stapels 2.1 angeordnet ist, wie Letzteres in der Position c der Figur 5 mit unterbrochenen Linien dargestellt ist.

Der Slow-Axis-Plattenfächer 10, der in Richtung der Fast-Axis bzw. in Richtung der X-Achse eine Höhe aufweist, die wenigstens gleich dem Abstand des in den Stapeln 2.1 und 2.2 untersten und in Richtung der X-Achse versetzten obersten Laserbarrens 4 ist, besteht wiederum aus einer Vielzahl von Platten 15 aus einem Licht leitenden Material, vorzugsweise aus einem optischen Glas, wobei die Platten 15 mit ihren aneinander anschließenden Oberflächenseiten in der YZ-Ebene orientiert sind. Jede Platte 15 ist wiederum mit zwei planen, jeweils senkrecht zu den Plattenoberflächenseiten orientierten und zueinander parallelen Plattenrandbereichen oder-seiten15.1 und 15.2 ausgebildet, von denen die Plattenrandseite 15.1 die Eintrittsseite und die Plattenrandseite 15.2 die Austrittsseite für die Laserlichtstrahlung ist. Um eine in Richtung der Fast-Axis oder in der X-Achse orientierte Achse sind die Platten 15 fächerartig gegeneinander verdreht, sodass die Ebenen der Plattenrandflächen 15.1 bzw. 15.2 benachbarter Platten wiederum um einen Winkelversatzdeutlich kleiner als 90° gegeneinander versetzt sind. Weiterhin ist auch der Slow-Axis-Plattenfächer 10 insbesondere hinsichtlich des Winkelversatzes zwischen benachbarten Platten 15 spiegelbildlich zu einer Mittelebene M des Slow-Axis-Plattenfächers 10 ausgeführt, die (Mittelebene) eine YZ-Ebene ist.

Um die Abmessung, die der Plattenfächer 10 in Richtung der Y-Achse bzw. der Slow-Axis aufweist, möglichst klein zu halten, weisen die Platten 15 bei der dargestellten Ausführungsform einen in etwa trapezartigen Zuschnitt auf, und zwar in der Weise, dass eine die Plattenrandseiten 15.1 und 15.2 verbindende Plattenseite 15.3 senkrecht oder in etwa senkrecht zu den Plattenrandseiten 15.1 und 15.2 orientiert ist und die andere, die Plattenrandseiten 15.1 und 15.2 verbindende Plattenseite 15.4 mit der Plattenrandseite 15.2 einen Winkel kleiner als 90° einschließt, sodass die Plattenrandseite 15.1 eine kürzere Länge als die Plattenrandseite 15.2 aufweist. Wie weiter in der Figur 2 zu entnehmen ist, sind die Platten 15 in dem Plattenfächer 10 bildenden Stapel derart angeordnet, dass die bezogen auf die X-Achse oberhalb der Mittelebene M des Plattenfächers 10 angeordneten Platten 15 zum Übereinanderschieben der Strahlenbündel 14.1 des einen Stapels, nämlich des Stapels 2.1 und die unterhalb der Mittelebene M angeordneten Platten 15 zum Übereinanderschieben der Strahlenbündel 14.1 des anderen Stapels, nämlich des Stapels 2.2 dienen. Hierfür sind die unteren Platten 15 gegenüber den oberen Platten gewendet, und zwar jeweils derart, dass die schräg verlaufende Plattenseite 15.1 jeweils an der Außenweite des Plattenfächers 10 angeordnet ist.

Die Mittelebene M des Slow-Axis-Plattenfächers 10 ist bei der dargestellten Ausführungsform auch die Mittelebene M der Laserdiodenanordnung 2 und schneidet die Achse, um die nicht nur die Platten 13 der Plattenfächer 9 gegeneinander verdreht, sondern auch die Plattenfächer 9 gegeneinander verschwenkt sind.

Da die beiden Fast-Axis-Plattenfächer 9 jeweils insgesamt gegenüber der Mittelebene M und relativ zueinander um ihre in der Y-Achse orientierte und in der Mittelebene M liegende Achse geschwenkt angeordnet sind, verlaufen bei der dargestellten Ausführungsform die Strahlenbündel 14.1 des einen Stapels, beispielsweise des Stapels 2.1 bei der für die Figur 1 gewählten Darstellung oberhalb der Mittelebene M und die Strahlenbündel 14.1 des anderen Stapels, beispielsweise des Stapels 2.2 unterhalb der Mittelebene M.

Nach dem Slow-Axis-Plattenfächer 10 erfolgt eine Slow-Axis-Kollimation der Strahlenbündel 14.2 mit dem Element 11 und anschließend eine Fokussierung der Strahlenbündel 14.2 mit der Fokussieroptik 12 in den in den Figuren mit FK bezeichneten Fokus.

Mit der beschriebenen Ausbildung ist bei kompakter Ausführung des Diodenlasers 1 eine erhöhte optische Leistung für diesen Diodenlaser möglich. Vorstehend wurde davon ausgegangen, dass die Laserdiodenanordnung 2 zwei Stapel 2.1 und 2.2 aufweist. Grundsätzlich können auch mehr als zwei Stapel verwendet sein, beispielsweise drei Stapel, wobei jedem Stapel wiederum ein Fast-Axis-Plattenfächer 9 zugeordnet ist und diese Plattenfächer in der betreffenden Fast-Axis-Plattenfächeranordnung 8 in Richtung der Y-Achse bzw. in Richtung der Slow-Axis um den Betrag a beabstandet sind.

Vorstehen wurde davon ausgegangen, dass die zusammen geschobenen Strahlenbündel 14.2 der beiden Stapel 2.1 und 2.2 in der Fast-Axis (X-Achse) derart gegeneinander versetzt sind, dass sämtliche Strahlenbündel 14.2 jedes Stapels unmittelbar an einander anschließen. Es besteht selbstverständlich auch die Möglichkeit, die Strahlenbündel 14 der Emitter der beiden Stapel 2.1 und 2.2 so umzuformen, dass nach dem Passieren des Slow-Axis-Plattenfächers 10 sich die Strahlenbündel 14.2 der beiden Stapel 2.1 und 2.2 in der Gesamtstrahlung in Richtung der Fast-Axis (X-Achse) abwechseln, d.h. in Richtung der X-Achse versetzt sind , so dass auf ein Strahlenbündel 14.2 des Stapels 2.1 ein Strahlenbündel 14.2 des Stapels 2.2 und auf dieses wiederum ein Strahlenbündel 14.2 des Stapels 2.1 usw. folgen, die Strahlenbündel 14.2 eines Stapels, beispielsweise des Stapels 2.1 also zwischen Lücken der Strahlenbündel 14.2 des anderen Stapels, beispielsweise des Stapels 2.2 in der gesamten Strahlung nach dem Stow-Axis-Plattenfächer 10 vorgesehen sind.

Weiterhin wurde vorstehend davon ausgegangen, dass die beiden Fast-Axis-Plattenfächer 9 der Fast-Axis-Plattenfächeranordnung 8 identisch ausgebildet sind. Grundsätzlich besteht aber auch die Möglichkeit, diese Plattenfächer unterschiedlich auszubilden, insbesondere hinsichtlich Größe der Ptatten 13, hinsichtlich des Verdrehungswinkels der Platten 13 relativ zueinander usw. um dadurch eine erwünschte Anpassung der Laser-Strahlung bzw. der Strahlenbündel 14.1 und 14.2 zu erreichen.

Als Material für die Plattenfächer 9 und 10 bzw. deren Platten 13 und 15 eigenen sich besonders hochtransparente Spezial- oder Quarzgläser, wobei alle optischen Flächen mit geeigneten Anti-Reflexions-Beschichtungen (AR-Beschichtungen) versehen sind.

Nach dem Slow-Axis-Kollimator 11 sind, der die gesamte Strahlung abdeckt, liegt eine im hohen Maße parallele Strahlung vor, die auch über eine größere Weglänge, beispielsweise über eine Weglänge bis zu einem Meter ohne nennenswerte Veränderung des Strahlendurchmessers übertragen werden kann.

Am Fokus FK wird die Laser-Strahlung beispielsweise über eine Faserkopplung in eine Faseroptik eingekoppelt oder die Fokussierung der Laser-Strahlung mit dem Element 12 erfolgt beispielsweise direkt auf eine mit der Laserstrahlung zu beaufschlagende Fläche, beispielsweise auf einen Werkstoff, um so eine unmittelbare Laser-Materialbearbeitung zu realisieren. Weiterhin kann die Fokussieroptik 12 auch über weitere optische Elemente, z.B. Linsenarrays verfügen, um homogenisierte Strahlungsfelder mit großflächiger Ausdehnung zu erzeugen.

Das vorbeschriebene optische Prinzip der erfindungsgemäßen Laseroptik für wenigstens zwei Laserbarrenstapel 2.1 und 2.2 ermöglicht es, die gesamte Leistung eines Diodenlasers wesentlich zu steigern. Diodenlaser mit lediglich einem Stapel erlauben bis maximal 13 Laserbarren und maximal 8 Stapeleinheiten, deren Strahlen zu einem gemeinsamen Ausgangsstrahl zusammengefasst werden, sodass Ausgangsleistungen bis zu 15 kW erreichbar sind. Eine höhere Anzahl von Laserbarren pro Stapel ist wegen der notwendigen effektiven Kühlung der Laserbarren nicht möglich. Für die Kühlung sind Wärmesenken bzw. aktive Kühler erforderlich, die eine Mindestbauhöhe von etwa 3,5 mm aufweisen. Die typische Höhe des Laserstrahls in Richtung der Fast-Axis beträgt aber nur 0,5 bis 1 mm, sodass der resultierende Laserstrahl eines Stapels im Strahlengang nach dem Fast-Axis-Kollimator eines solchen Stapels über relativ große, nicht strahlende Bereiche verfügt.

Durch die Verwendung von wenigstens zwei in Richtung der Slow-Axis gegeneinander versetzten Stapeln 2.1 und 2.2 kann die Anzahl der Laserbarren und Emitter im System verdoppelt werden, sodass Ausgangsleistungen bis zu 30 kW erreichbar sind. Durch die vorbeschriebene Ausbildung des Diodenlasers und dessen Laseroptik wird die Strahlung des einen Stapels mit der Strahlung des anderen Stapels überlagert, und zwar dadurch, dass die Strahlung des anderen Stapels 2.2 in die Lücken der Strahlung des ersten Stapels 2.1 eingefügt wird.

Völlig neuartig ist bei dem vorbeschriebenen Diodenlaser, dass die Strahlung der wenigstens zwei Stapel 2.1 und 2.2 durch zwei getrennte, in der Fast-Axis wirkende Plattenfächer jeweils eigenständig getrennt, d.h. aufgefächert wird und die aufgefächerte Strahlung jedes Stapels anschließend durch den Slow-Axis-Plattenfächer 10 in der Slow-Axis übereinander geschoben wird. Dies erfolgt so, dass sämtliche in der Fast-Axis vorhandenen Bereiche ohne Strahlung komplett ausgefüllt werden, sodass am Austritt des Slow-Axis Plattenfächers 9 eine lückenfreie oder im Wesentlichen lückenfreie Verteilung der Laserstrahlung in Richtung der Fast-Axis vorliegt.

Mit der erfindungsgemäße Ausbildung wird insbesondere auch durch die Fast-Axis-Plattenfächer 8 eine verbesserte Strahlenqualität erreicht, sodass u.a. die Möglichkeit besteht, die Laserstrahlung in runde Fasern mit einem Durchmesser von 1,2 bis 2.0 mm einer Faseroptik einzukoppeln.

In der Praxis möglich wäre z.B. eine Anordnung mit zwei Stapeln (Doppelstapelanordnung) und einer dreifachen Teilung oder Auffächerung der Strahlung jedes Stapels 2.1 und 2.2 im Fast-Axis-Plattenfächer 8 (Doppelstapelanordnung mit maximal 26 Laserbarren; die achtfache Anordnung der Doppelstapelanordnung ergibt eine maximale Ausgangsleistung von 30kW) oder aber alternativ eine Anordnung mit drei Stapeln (Dreifachstapelanordnung) mit jeweils zweifacher Teilung oder Auffächerung der Strahlung jedes Stapels im Fast-Axis-Plattenfächer 8 (drei Stapel mit maximal 39 Bauteilen; die achtfacher Anordnung der Dreifachstapelanordnungen ergibt eine maximale Ausgangsleistung 45 kW).

### Bezugszeichenliste

- 1: Diodenlaser
- 2: Laserdiodenanordnung
- 2.1, 2.2: Stapel
- 3: Wärmesenke
- 4: Laserbarren
- 4.1: Emitter
- 5: Einzel-Laser-Strahl
- 6: Fast-Axis-Kollimator
- 7: optische Anordnung
- 8: Fast-Axis-Plattenfächeranordnung
- 9: Fast-Axis-Plattenfächer
- 10: Slow-Axis-Plattenfächer
- 11: Slow-Axis-Kollimator
- 12: Fokussieroptik
- 13: Platte
- 13.1, 13.2: Plattenrandbereich
- 14: Strahlenbündel
- 14.1: aufgefächertes Strahlenbündel
- 14.2: umgeformtes oder zusammen geschobenes Strahlenbündel
- 15: Platte
- 15.1, 15.2: Plattenrandbereich
- 15.3, 15.4: Plattenrand
- a: Abstand zwischen den Plattenfächern
- α: Verdrehwinkel zwischen den Platterifächern 9 der Plattenfächeranordnung 8
- M: senkrecht zur Fast-Axis orientierte Mittelebene der Laserdiodenanordnung 2 sowie der optischen Anordnung 7
- X: X-Achse
- Y: Y-Achse
- Z: Z-Achse sowie Achse der optischen Anordnung 7

## Patentansprüche

1. Diodenlaser mit einer eine Vielzahl von Laserbarren (4) aufweisenden Laserdiodenanordnung (2), wobei jeder Laserbarren (4) an einer Stirnseite eines Trägers (3) angeordnet ist und in einer einer Slow-Axis (Y-Achse) der Laserstrahlen (5) entsprechenden ersten Achsrichtung (Y-Achse) gegeneinander versetzt mehrere Laserstrahlen (5) erzeugende Emitter (4.1) aufweist, wobei die Laserbarren (4) mit ihren Trägern (3) zur Ausbildung der Laserdiodenanordnung (2) in einer der Fast-Axis der Laserstrahlen (5) entsprechenden und senkrecht zur ersten Achsrichtung (Y-Achse) orientierten zweiten Achsrichtung (X-Achse) in wenigsten zwei Stapeln stapelartig gegeneinander versetzt vorgesehen sind, mit Fast-Axis-Kollimatoren (6), von denen jeweils wenigstens einer jedem der parallel zueinander angeordneten Laserbarren (4) zugeordnet ist, sowie mit einer optischen Anordnung (7) zum Umformen von Laser-Strahlenbündel, welche aus den von den Emittern (4.1) erzeugten Laserstrahlen (5) bestehen, wobei die optische Anordnung (7) zumindest eine Fast-Axis-Plattenfächeranordnung (8) zum Auffächern des Laser-Strahlenbündels in der Fast-Axis (X-Achse) sowie auf die Fast-Axis-Plattenfächeranordnung (8) im Strahlengang folgend eine Slow-Axis-Plattenfächeranordnung (10) zum Zusammenführen des aufgefächerten Laser-Strahlenbündels in der Slow-Axis (Y-Achse) aufweist,
**dadurch gekennzeichnet,**
**dass** die Laserbarren (4) mit ihren Trägern (3) in der Laserdiodenanordnung (2) wenigstens zwei in der Slow-Axis (Y-Achse) gegeneinander versetzte Stapel (2.1, 2.2) mit jeweils einer Vielzahl von in der Fast-Axis (X-Achse) zusammen mit ihren Trägern (3) stapelartig gegeneinander versetzten Laserbarren (4) bilden und
**dass** die Fast-Axis-Plattenfächeranordnung (8) wenigstens zwei parallel zueinander und in Richtung der Slow-Axis (Y-Achse) der Laserstrahlung voneinander beabstandete und um einen Winkelbetrag gegeneinander verdrehte Fast-Axis-Plattenfächer (9) zur Ausbildung jeweils wenigstens eines eigenen aufgefächerten Laserstrahlbündels (14.1) für jeden Stapel aufweist, und dass die Laserstrahl bündels (14.1) der wenigstens zwei Stapel getrennt und in der Fast-Axis gegen einander versetzt sind.

2. Diodenlaser nach Anspruch 1, **dadurch gekennzeichnet, dass** die Anzahl der Fast-Axis-Plattenfächer (9) der Fast-Axis-Plattenfächeranordnung (8) gleich der Anzahl der Stapel (2.1, 2.2) der Diodenlaseranordnung (2) ist.

3. Diodenlaser nach Anspruch 1 oder 2, **dadurch gekennzeichnet, dass** die Breite, die der jeweilige Fast-Axis-Plattenfächer (9) der Fast-Axis-Plattenfächeranordnung (8) in Richtung der Slow-Axis (Y-Achse) der Laserstrahlung aufweist gleich der Breite ist, die die Laserbarren (4) in der Slow-Axis (Y-Achse) aufweisen, oder aber gleich dem maximalen Abstand ist, den zwei Emitter (4.1) an den Laserbarren (4) aufweisen.

4. Diodenlaser nach einem der vorhergehenden Ansprüche, **dadurch gekennzeichnet, dass** die wenigstens zwei Fast-Axis-Plattenfächer (9) der Fast-Axis-Plattenfächeranordnung (8) jeweils aus mehreren Platten (13) aus einem Licht leitenden Material bestehen, dass die Platten (13) mit ihren gegeneinander anliegenden Oberflächenseiten in einer senkrecht zur Slow-Axis (Y-Achse) der Laserstrahlung orientiert sind und an zwei einander gegenüberliegenden sowie senkrecht zu den Plattenoberflächenseiten orientierten Plattenrandbereichen (13.1, 13.2) eine Eintrittsseite oder eine Austrittsseite für Laserstrahlung bilden, und dass die Platten (13) in jedem Fast-Axis-Plattenfächer (9) derart fächerartig gegeneinander verdreht vorgesehen sind, dass sowohl die Eintrittsseite als auch die Austrittsseite jeder Platte (13) mit der Eintrittsseite oder Austrittsseite der benachbarten Platte einen einen spitzen Winkel bildenden Winkelversatz aufweist.

5. Diodenlaser nach einem der vorhergehenden Ansprüche, **dadurch gekennzeichnet, dass** die wenigstens zwei die Fast-Axis-Plattenfächeranordnung (8) bildenden Fast-Axis-Plattenfächer (9) um die Slow-Axis (Y-Achse) gegeneinander verdreht vorgesehen sind, die auch diejenige Achse ist, um die die einzelnen Platten (13) jedes Fast-Axis-Plattenfächers (9) fächerartig gegeneinander verdreht sind.

6. Diodenlaser nach einem der vorhergehenden Ansprüche, **dadurch gekennzeichnet,**
**dass** die Slow-Axis-Plattenfächeranordnung wenigstens zwei Slow-Axis-Plattenfächer (10) aufweist,
**dass** jeder Slow-Axis-Plattenfächer (10) der Slow-Axis-Plattenfächeranordnung aus mehreren Platten (15) aus einem Licht leitenden Material besteht, die mit ihren aneinander anschließenden Oberflächenseiten senkrecht zur Fast-Axis (X-Achse) der Laserstrahlung orientiert sind und an zwei einander gegenüberliegenden Plattenrandbereichen (15.1, 15.2) eine Eintrittsseite und eine Austrittsseite für die Laserstrahlung bilden und die um eine Achse parallel zur Fast-Axis (X-Achse) der Laserstrahlung fächerartig gegeneinander verdreht sind, sodass jede Eintrittsseite und Austrittsseite einer Platte (15) gegenüber der benachbarten Eintrittsseite und Austrittsseite der benachbarten Platte (15) einen einen spitzen Winkel bildenden Winkelversatz aufweist, und
**dass** die wenigstens zwei Slow-Axis-Plattenfächer (10) hinsichtlich Form und/oder Anordnung ihrer Platten (15)spiegelsymmetrisch zu einer senkrecht zur Fast-Axis (X-Achse) der Laserstrahlung orientierten Mittelebene (M) der Slow-Axis-Plattenfächeranordnung ausgebildet sind.

7. Diodenlaser nach einem der vorhergehenden Ansprüche, **gekennzeichnet durch** eine Slow-Axis-Kollimator-Optik (11), die im Strahlengang der Laserstrahlung auf die Slow-Axis-Plattenfächeranordnung (10) folgend angeordnet ist und die gesamte Laser-Strahlung abdeckt.

8. Diodenlaser nach einem der vorhergehenden Ansprüche, **gekennzeichnet durch** eine Fokussieroptik (12) zum Fokussieren der Laserstrahlung in einem Fokus (FK) auf eine mit der Laserstrahlung zu behandelnden Fläche oder auf eine Faserkopplung zum Einkoppeln in eine Faseroptik.

9. Diodenlaser nach einem der vorhergehenden Ansprüche, **gekennzeichnet durch** eine Fokussieroptik (12) mit weiteren optischen Elementen, um ein homogenisiertes Strahlungsfeld mit einer großflächigen Ausdehnung zu erzeugen.

10. Diodenlaser nach einem der Ansprüche 4 - 9, **dadurch gekennzeichnet,**
**dass** Licht leitenden Material ein optisches Glas ist.

11. Diodenlaser nach einem der Ansprüche 4 - 10, dass die Eintritts- und Austrittsseiten für Laserstrahlung parallel zueinander verlaufenden Plattenrandbereichen (13.1, 13.2; 15.1, 15.2) der Platten (13. 15) ausgebildet sind.

## Claims

1. Diode laser with a laser diode array (2) having a plurality of laser bars (4), wherein each laser bar (4) is arranged on a face side of a carrier (3) and in a first axial direction (Y-axis) corresponding to a slow axis (Y-axis) of the laser beams (5) comprises a plurality of emitters (4.1) generating laser beams (5) that are offset against each other, wherein in order to form the laser diode array (2) the laser bars (4) with their carriers (3) are stacked in a second axial direction (X-axis), corresponding to the fast axis of the laser beams (5) and oriented perpendicular to the first axial direction (Y-axis), in at least two stacks that are offset against each other, with fast axis collimators (6), at least one of which in each case is assigned to each of the laser bars (4) arranged parallel to each other, and with an optical arrangement (7) for converting bundles of laser beams consisting of the laser beams (5) generated by the emitters (4.1), wherein the optical arrangement (7) has at least one fast-axis plate spreader arrangement (8) for fanning out the bundle of laser beams in the fast axis (X-axis), and has a slow-axis plate spreader arrangement (10) behind the fast-axis plate spreader arrangement (8) in the beam path for merging the fanned bundle of laser beams in the slow axis (Y-axis),
**characterized in that**
the laser bars (4) with their carriers (3) in the laser diode array (2) form at least two stacks (2.1, 2.2) offset against each other in the slow axis (Y-axis), each having a plurality of laser bars (4) that are offset against each other in a stack-like manner in the fast axis (X-axis) together with their carriers (3),
and **in that** the fast-axis plate spreader arrangement (8) has at least two fast-axis plate spreaders (9) which are parallel to each other and spaced apart from each other in the direction of the slow axis (Y-axis) of the laser radiation and twisted relative to each other by an angular value, for forming in each case at least one individual fanned laser beam (14.1) for each stack, and **in that** the laser beams (14.1) of the at least two stacks are separated and offset against each other in the fast axis.

2. Diode laser according to claim 1, **characterized in that** the number of the fast axis-plate spreaders (9) of the fast-axis plate spreader arrangement (8) is equal to the number of the stacks (2.1, 2.2) of the diode laser arrangement (2).

3. Diode laser according to claim 1 or 2, **characterized in that** the width of the respective fast-axis plate spreader (9) of the fast-axis plate spreader arrangement (8) in the direction of the slow axis (Y-axis) of the laser radiation is either equal to the width of the laser bars (4) in the slow axis (Y-axis), or equal to the maximum distance, between two emitters (4.1) on the laser bars (4).

4. Diode laser according to any one of the preceding claims, **characterized in that** the at least two fast-axis plate spreaders (9) of the fast-axis plate spreader arrangement (8) each consist of a plurality of plates (13) made of a light-conducting material, **in that** the plates (13) are oriented with their upper surfaces aligned adjacent to each other perpendicular to the slow axis (Y-axis) of the laser radiation and on two plate boundary areas (13.1, 13.2), which are opposite each other and perpendicular to the upper plate surfaces, form an inlet side or an outlet side for laser radiation, and that the plates (13) in each fast-axis plate spreader (9) are twisted in a fan-shaped manner relative to each other, in such a way that both the inlet side and the outlet side of each plate (13) have an angular offset with the inlet side or outlet side of the adjacent plate, forming an acute angle.

5. Diode laser according to any one of the preceding claims, **characterized in that** the at least two fast-axis plate spreaders (9) forming the fast-axis plate spreader arrangement (8) are twisted relative to each other about the slow axis (Y-axis), which is also the same axis about which the individual plates (13) of each fast-axis plate spreader (9) are twisted relative to each other in a fan-shaped manner.

6. Diode laser according to any one of the preceding claims, **characterized in that** the slow-axis plate spreader arrangement has at least two slow-axis plate spreaders (10),
**in that** each slow-axis plate spreader (10) of the slow-axis plate spreader arrangement consists of a plurality of plates (15) made of a light-conducting material, which are oriented with their adjacent upper surfaces perpendicular to the fast axis (X-axis) of the laser radiation and at two opposite plate edge areas (15.1, 15.2) form an inlet side and an outlet side for the laser radiation, and which are twisted in a fan-shaped manner relative to each other about an axis parallel to the fast axis (X-axis) of the laser radiation so that each inlet side and outlet side of a plate (15) has an angular offset relative to the adjacent inlet side and outlet side of the adjacent plate (15) forming an acute angle, and
**in that** the at least two slow-axis plate spreaders (10) as regards the shape and/or arrangement of their plates (15) are implemented mirror symmetrically with respect to a central plane (M) of the slow axis-plate spreader arrangement oriented perpendicular to the fast axis (X-axis) of the laser radiation.

7. Diode laser according to any one of the preceding claims, **characterized by** a slow-axis collimator optics (11) which is arranged in the beam path of the laser radiation behind the slow-axis plate spreader arrangement (10) and which covers the whole of the laser radiation.

8. Diode laser according to any one of the previous claims, **characterized by** a focussing optics (12) for focussing the laser radiation at a focus (FK) onto a surface to be treated with the laser radiation, or onto a fibre coupling for coupling into an optical fibre.

9. Diode laser according to any one of the preceding claims, **characterized by** a focussing optics (12) with further optical elements, to create a homogenised radiation field with a large areal extension.

10. Diode laser according to any one of claims 4 - 9, **characterized in that** light-conducting material is an optical glass.

11. Diode laser according to any one of claims 4 - 10, **characterized in that** the inlet and outlet sides for laser radiation are designed as plate boundary areas (13.1, 13.2, 15.1, 15.2) of the plates (13, 15) extending parallel to each other.

## Revendications

1. Laser à diodes avec un dispositif de diodes laser (2) présentant une pluralité de barres de laser (4), dans lequel chaque barre de laser (4) est disposée sur un côté frontal d'un support (3) et présente, dans une première direction d'axe (axe Y) correspondant à un slow-axis (axe Y) des rayons laser (5), des émetteurs (4.1) décalés les uns par rapport aux autres générant plusieurs rayons laser (5), dans lequel les barres de laser (4) avec leurs supports (3) sont prévues, pour la formation du dispositif de diodes laser (2), en au moins deux piles de façon décalée les unes par rapport aux autres à la manière de piles dans une deuxième direction d'axe (axe X) correspondant au fast-axis des rayons laser (5) et orientée perpendiculairement à la première direction d'axe (axe Y), avec des collimateurs fast-axis (6) dont respectivement l'un au moins d'entre eux est associé à chacune des barres de laser (4) disposées parallèlement entre elles, ainsi qu'avec un dispositif optique (7) pour déformer des faisceaux de rayons laser qui se composent des rayons laser (5) générés par l'émetteur (4.1), dans lequel le dispositif optique (7) présente au moins un dispositif d'éventails en plaques fast-axis (8) pour étaler en éventail le faisceau de rayons laser dans le fast-axis (axe X) ainsi que, à la suite du dispositif d'éventails en plaques fast-axis (8) dans la trajectoire des rayons, un dispositif d'éventails en plaques slow-axis (10) pour réunir le faisceau de rayons laser étalé en éventail dans le slow-axis (axe Y) ;
**caractérisé en ce que**
les barres de laser (4) avec leurs supports (3) dans le dispositif de diodes laser (2) forment au moins deux piles (2.1, 2.2) décalées l'une par rapport à l'autre dans le slow-axis (axe Y) avec respectivement une pluralité de barres de laser (4) décalées les unes par rapport aux autres à la manière de piles, ensemble avec leurs supports (3) dans le fast-axis (axe X) et
**en ce que** le dispositif d'éventails en plaques fast-axis (8) présente au moins deux éventails en plaques fast-axis (9) parallèles entre eux et espacés l'un de l'autre en direction du slow-axis (axe Y) du rayonnement laser et en torsion l'un par rapport à l'autre de l'ordre d'une valeur angulaire pour la formation respectivement d'au moins un faisceau de rayons laser (14.1) étalé en éventail propre pour chaque pile, et **en ce que** les faisceaux de rayons laser (14.1) des au moins deux piles sont séparés et décalés les uns par rapport aux autres dans le fast-axis.

2. Laser à diodes selon la revendication 1, **caractérisé en ce que** le nombre des éventails en plaques fast-axis (9) du dispositif d'éventails en plaques fast-axis (8) est égal au nombre de piles (2.1, 2.2) du dispositif de diodes laser (2).

3. Laser à diodes selon la revendication 1 ou 2, **caractérisé en ce que** la largeur que présente l'éventail en plaques fast-axis (9) respectif du dispositif d'éventails en plaques fast-axis (8) en direction du slow-axis (axe Y) du rayonnement laser est égale à la largeur que présentent les barres de laser (4) dans le slow-axis (axe Y), ou bien est égale à la distance maximale que présentent deux émetteurs (4.1) sur les barres de laser (4).

4. Laser à diodes selon l'une des revendications précédentes, **caractérisé en ce que** les au moins deux éventails en plaques fast-axis (9) du dispositif d'éventails en plaques fast-axis (8) se composent respectivement de plusieurs plaques (13) en un matériau conduisant la lumière, **en ce que** les plaques (13) sont orientées, avec leurs côtés de surface supérieure reposant l'un contre l'autre, perpendiculairement au slow-axis (axe Y) du rayonnement laser et forment, au niveau de deux zones de bord de plaque (13.1, 13.2) situées en vis-à-vis l'une de l'autre et orientées perpendiculairement aux côtés de surface supérieure, un côté d'entrée ou un côté de sortie pour le rayonnement laser, et **en ce que** les plaques (13) dans chaque éventail en plaques fast-axis (9) sont prévues en torsion les unes par rapport aux autres à la manière d'un éventail de telle sorte que le côté d'entrée tout comme également le côté de sortie de chaque plaque (13) présente, avec le côté d'entrée ou le côté de sortie de la plaque voisine, un décalage angulaire formant un angle aigu.

5. Laser à diodes selon l'une des revendications précédentes, **caractérisé en ce que** les au moins deux éventails en plaques fast-axis (9) formant le dispositif d'éventails en plaques fast-axis (8) sont prévus en torsion l'un par rapport à l'autre autour du slow-axis (axe Y) qui est également celui des axes autour duquel les plaques individuelles (13) de chaque éventail en plaques fast-axis (9) sont en torsion les unes par rapport aux autres à la manière d'un éventail.

6. Laser à diodes selon l'une des revendications précédentes, **caractérisé en ce que** le dispositif d'éventails en plaques slow-axis présente au moins deux éventails en plaques slow-axis (10),
**en ce que** chaque éventail en plaques slow-axis (10) du dispositif d'éventails en plaques slow-axis se compose de plusieurs plaques (15) en un matériau conduisant la lumière, lesquelles sont orientées avec leurs côtés de surface supérieure en jonction l'un avec l'autre perpendiculairement au fast-axis (axe X) du rayonnement laser et forment, au niveau de deux zones de bord de plaque (15.1, 15.2) situées en vis-à-vis l'une de l'autre, un côté d'entrée et un côté de sortie pour le rayonnement laser, et lesquelles sont en torsion les unes par rapport aux autres à la manière d'un éventail autour d'un axe parallèle au fast-axis (axe X) du rayonnement laser de sorte que chaque côté d'entrée et côté de sortie d'une plaque (15) présente, par rapport au côté d'entrée et côté de sortie de la plaque voisine (15), un décalage angulaire formant un angle aigu, et
**en ce que**, concernant la forme et/ou la disposition de leurs plaques (15), les au moins deux éventails en plaques slow-axis (10) sont réalisés en symétrie spéculaire par rapport à un plan médian (M) orienté perpendiculairement au fast-axis (axe X) du rayonnement laser du dispositif d'éventails en plaques slow-axis.

7. Laser à diodes selon l'une des revendications précédentes, **caractérisé par** une optique à collimateur slow-axis (11) qui est disposée dans la trajectoire des rayons du rayonnement laser à la suite du dispositif d'éventails en plaques slow-axis (10) et recouvre l'ensemble du rayonnement laser.

8. Laser à diodes selon l'une des revendications précédentes, **caractérisé par** une optique de focalisation (12) pour la focalisation du rayonnement laser dans un foyer (FK) sur une surface à traiter avec le rayonnement laser ou sur un couplage de fibres pour l'injection dans une optique à fibres.

9. Laser à diodes selon l'une des revendications précédentes, **caractérisé par** une optique de focalisation (12) avec d'autres éléments optiques afin de générer un champ de rayonnement homogénéisé avec une extension sur une grande surface.

10. Laser à diodes selon l'une des revendications 4-9, **caractérisé en ce que** le matériau conduisant la lumière est un verre optique.

11. Laser à diodes selon l'une des revendications 4-10, **caractérisé en ce que** les côtés d'entrée et de sortie pour un rayonnement laser sont réalisés sur des zones de bord de plaque (13.1, 13.2 ; 15.1, 15.2) des plaques (13, 15) s'étendant parallèlement les unes par rapport aux autres.
